# EUROPEAN PATENT SPECIFICATION

(11) **EP 3 197 112 B1**
(45) Date of publication and mention of the grant of the patent: **18.09.2019**
(21) Application number: 14881449.4
(22) Date of filing: 22.12.2014
(51) Int. Cl.: H04L 12/931, G06F 1/18, H05K 7/14

(54) **BACK PANEL STRUCTURE AND CENTRALIZED SWITCHING DEVICE**
RÜCKWANDSTRUKTUR UND ZENTRALISIERTE SCHALTVORRICHTUNG
STRUCTURE DE PANNEAU ARRIÈRE ET DISPOSITIF DE COMMUTATION CENTRALISÉ

(30) Priority: 21.07.2014 CN 201410348765
(43) Date of publication of application: 26.07.2017
(73) Proprietor: ZTE Corporation, Shenzhen, Guangdong 518057 (CN)
(72) Inventor: LIU, Yu, Shenzhen Guangdong 518057 (CN); YE, Bing, Shenzhen Guangdong 518057 (CN)
(74) Representative: Aipex B.V.
(86) International application number: PCT/CN2014/094559
(87) International publication number: WO 2015/117519

(56) References cited:
- CN-A- 1 859 244
- CN-A- 101 242 281
- CN-A- 102 714 372
- CN-A- 102 809 784
- US-A1- 2002 172 273
- US-A1- 2003 142 483
- US-A1- 2013 279 501
- US-B1- 8 218 537

## Description

### Technical Field

The present invention relates to the field of a centralized cross backboard, and in particular, to a backboard structure and a centralized switching device.

### Background

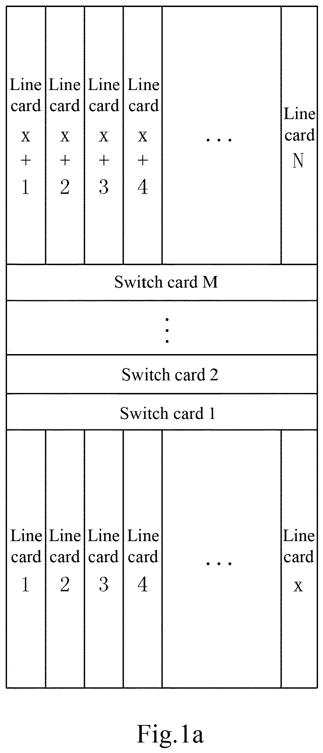

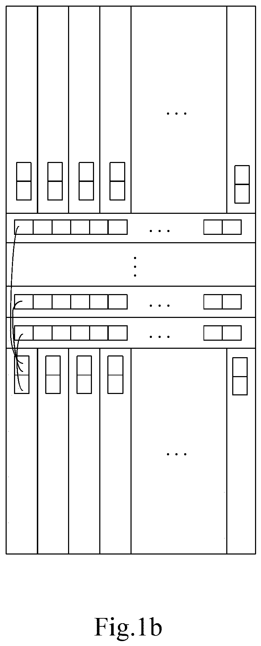

A centralized switching device is mainly applied to fields based on an Optical Transport Network (called OTN), a Packet Transfer Network (called PTN), and an Internet Protocol (called IP). Along with the rapid development of Internet and 3G/4G services, the demand of a market for the scheduling capacity of the switching device is larger and larger. At present, the existing technology of the centralized cross device is mainly to realize interconnection of high-speed paths through backboard lines. In the industry, the implementation mode of the latest high-capacity backboard is a design of a belt type, as shown in FIG. 1a and 1b.

FIG. 1a and 1b show a device structure with three layers at one side. The capacity of six layers at double sides is double, and the structure of the other side is basically as same as that in the FIG. 1. Here, a brief introduction is made with three layers at one side as an example. M switch cards are inserted laterally in the middle, and single boards vertically inserted on the upper and lower layers are N line cards. The line cards on the lower layer are forward inserted cards, and the single boards on the lower layer are backward inserted cards. High-speed socket positions are shown in small boxes of FIG. 1b. At the moment of designing, distances between line card sockets and switch card sockets are kept as close as possible, to ensure the performance of the high-speed signals. That design can guarantee reliable transmission of 12.5G high-speed signals of the backboard. In the case of a single slot with 400G, about 25T of the total capacity of the device is achieved.

Limited by the fabrication performance of a Printed Circuit Board (called as PCB), 25/28G transmission performance of a backboard cannot be reliably guaranteed. Limited by the requirement of an operator room for a device size, and the single board with double sides can only use the same depth, thus the design space of the single board is small. There are many difficulties on implementation of the design of the single slot 400G, and further it is almost impossible to implement a design of a single slot 800G/1T. Herein, the bandwidth and capacity unit of the device is Gbps (10 to the 9 bit per second) or Tbps (10 to the 12 bit per second), which represents the amount of data able to be transmitted or switched by the device per second, usually abbreviated as G or T.

Regarding the above problems in the related art, there is no effective solution till now.

US 8218537 B1 discloses a serial channel switch circuit and modular packet switch using the serial channel switch circuits.

US2003142483 A1 discloses a switching device comprising at least one line card and at least one switching card, as well as a mid-plane coupled to the at least one line card and the at least one switching card, wherein the at least one switching card and the at least one line card are perpendicular to each other, such that the interconnections are short and can be implemented in a few layers.

### Summary of the Invention

Regarding the technical problems of poor transmission performance of the existing backboard solution and small design space of a single board in the related art, the present invention provides a backboard structure and centralized switching device according to appended independent claims, to solve at least the above technical problems. Further improvements and embodiments are provided in the dependent claims.

Also provided is a backboard structure according to an embodiment of the present invention. The backboard structure includes a backboard, and further includes: a line card, arranged at a front side of the backboard; and a switch card, arranged at a back side of the backboard.

In an exemplary embodiment, the backboard structure further includes: a first socket for connecting the line card to the switch card, arranged at the front side of the backboard; a second socket for connecting the switch card to the line card, arranged at the back side of the backboard. The first socket and the second socket are orthogonally arranged on a same layer.

In an exemplary embodiment, the first socket is directly connected with the second socket through the backboard.

In an exemplary embodiment, the backboard structure further includes: the third socket, arranged on the backboard, and connected with the first socket; a fourth socket connected with the third socket, arranged on the backboard, and connected to the switch card. The first socket is connected with the second socket through the third socket and the fourth socket.

In an exemplary embodiment, the backboard structure further includes: a cable box, arranged on the backboard, for cross-layer connecting the switch card and the line card.

In an exemplary embodiment, the backboard structure further includes: a fifth socket for connecting the line card to the cable box, and a sixth socket for connecting the cable box to the line card; a seventh socket for connecting the switch card to the cable box, and an eighth socket for connecting the cable box to the switch card.

In an exemplary embodiment, the fifth socket is directly connected with the sixth socket across the backboard; or, the fifth socket is indirectly connected with the sixth socket through a ninth socket arranged on the backboard.

In an exemplary embodiment, the sixth socket is arranged adjacent to a panel of the switch card.

In an exemplary embodiment, the second socket and the sixth socket are respectively arranged at both sides of a switch chip on the switch card.

In an exemplary embodiment, the cable box and the switch card are arranged at a same side of the backboard.

In an exemplary embodiment, the cable box and the switch card are arranged in parallel.

Also provided is a centralized switching device, including a switch card and a line card, and further including the above backboard structure.

The present invention adopts the technical means of arranging the first socket for connecting the line card to the switch card and the second socket for connecting the switch card to the line card respectively at two sides of the backboard, to solve the problems of poor transmission performance of a backboard solution and small design space of a single board in the related art. Therefore, the requirement for path loss of high-speed signals is met, and the design space of the single board is increased at the same time.

### Description of Drawings

The accompanying drawings described herein are used to provide further understanding for the present invention and constitute a part of the present application. The illustrated embodiments of the present invention and the description thereof are used to explain the present invention, rather than constituting an inappropriate limitation to the present invention. Herein:
FIG. 1a is a structural diagram of a belt type centralized switch sub-rack according to the related art.
FIG. 1b is another structural diagram of a belt type centralized switch sub-rack according to the related art.
FIG. 2a is a schematic diagram of a front side of a centralized cross sub-rack based on a cable backboard according to an embodiment of the present invention.
FIG. 2b is a schematic diagram of a back side of a centralized cross sub-rack based on a cable backboard according to an embodiment of the present invention.
FIG. 2c is a schematic diagram of a side of a centralized cross sub-rack based on a cable backboard according to an embodiment of the present invention.
FIG. 3a is a side view of a cable backboard scheme according to an embodiment of the present invention.
FIG. 3b is a plan view of a cable backboard scheme according to an embodiment of the present invention.
FIG. 4 is a schematic diagram of a design of a cable box according to an embodiment of the present invention.
FIG. 5a is a schematic diagram of a front side of a double-layer switch card according to an embodiment 1 of the present invention.
FIG. 5b is a schematic diagram of a back side of a double-layer switch card according to an embodiment 1 of the present invention.
FIG. 5c is a schematic diagram of a profile of a cable box of a double-layer switch card according to an embodiment 1 of the present invention.
FIG. 6a is a schematic diagram of a front side of a three-layer switch card according to an embodiment 2 of the present invention.
FIG. 6b is a schematic diagram of a back side of a three-layer switch card according to an embodiment 2 of the present invention.
FIG. 6c is a schematic diagram of a profile of a cable box of a three-layer switch card according to an embodiment 2 of the present invention.
FIG. 7a is a schematic diagram of a front side of a four-layer switch card according to an embodiment 3 of the present invention.
FIG. 7b is a schematic diagram of a back side of a four-layer switch card according to an embodiment 3 of the present invention.
FIG. 7c is a schematic diagram of a profile of a cable box of a four-layer switch card according to an embodiment 3 of the present invention.

### Specific Embodiments

The present invention is described in detail with reference to the accompanying drawings and in combination with embodiments hereinafter. It should be illustrated that, in the case of not conflicting, the embodiments in the present application and features in these embodiments can be combined with each other.

The line card in the present embodiment may be called service board, line board, customer board, branch board, etc., in various devices, and is a PCB board card which supports the external service access and communicates with the switch board card through the socket of the backboard.

The switch card may be called switch board, switch board card, cross board, etc., in various devices, which is a PCB board card for connecting the switch or cross scheduling function among various line cards.

The cable backboard (referred to as the backboard for short) is a backboard concept in a board sense, including backboard PCB. A cable box for implementing the high-speed interconnection between the line card and the switch card in the following embodiments (including socket and high speed cable) is arranged on the backboard.

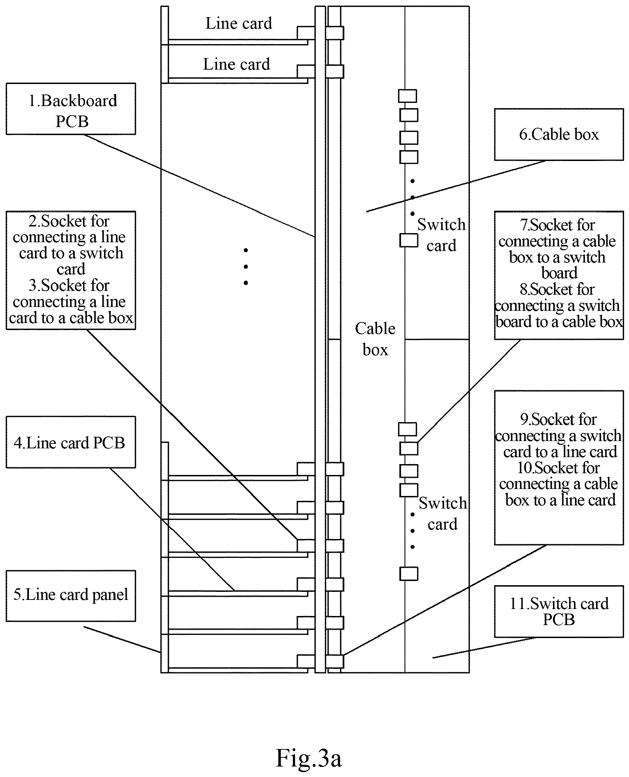

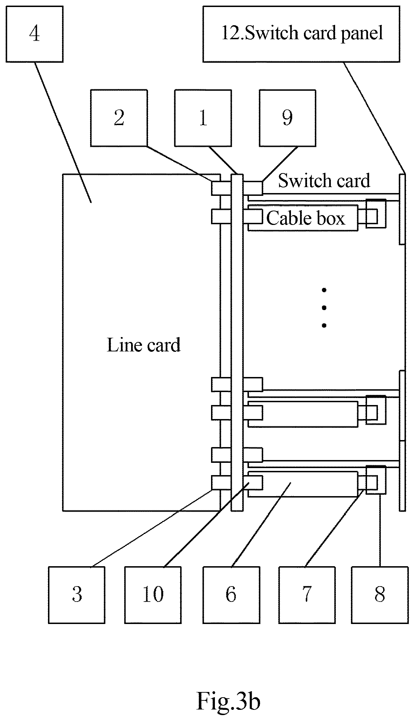

A backboard structure, as shown in FIG. 3a and 3b, includes: a backboard 1, a first socket 2 for connecting the line card to the switch card, arranged at the front side of the backboard 1; a second socket 9 for connecting the switch card to the line card, arranged at the back side of the backboard 1. The first socket 2 and the second socket 9 are orthogonally arranged on the same layer.

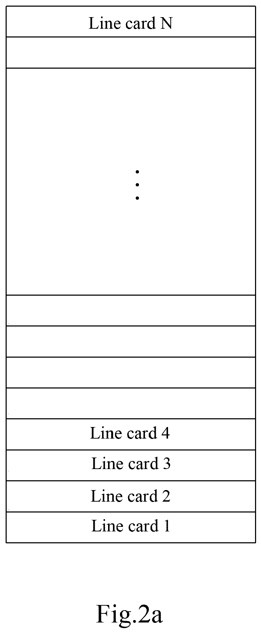

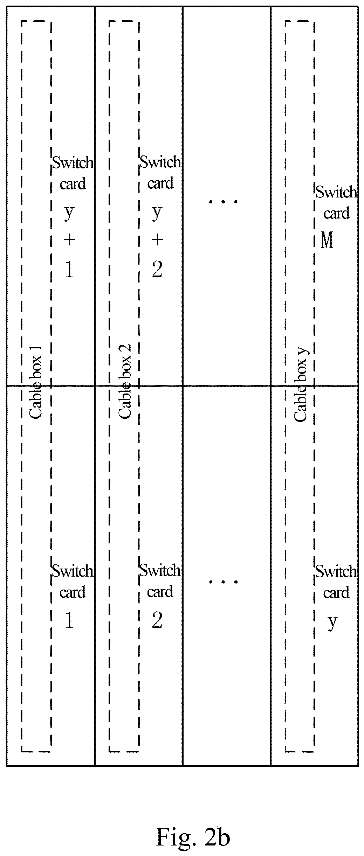

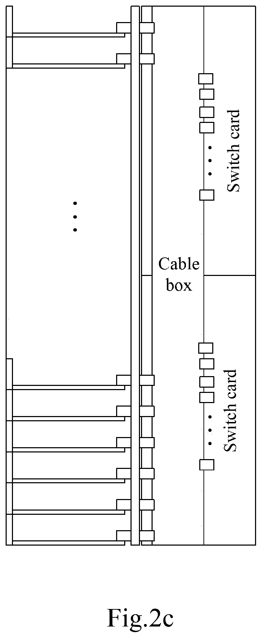

It can be seen from the above structure, the line card and the switch card are arranged at different sides of the backboard, that is, the line card is arranged at the front side of the back plane, and the switch card is arranged at the back side of the backboard (as shown in FIG. 2a, 2b and 2c). As shown in FIG. 3a and 3b, the line card in the present embodiment includes a line card PCB 4 and a line card panel 5, and the switch card in the present embodiment includes a switch card PCB 11 and a switch card panel 12.

The first socket 2 and the second socket 9 are connected directly through the backboard 1.

The third socket 13 (not shown in the figure) is arranged on the backboard 1 and is connected with the first socket 2. The fourth socket 14 connected with the third socket 14 (not shown in the figure) is arranged on the backboard 1 and is connected with the switch card. The first socket 2 is connected with the second socket 9 through the third socket 13 and the fourth socket 14.

The backboard structure provided by the present embodiment may also include: a cable box 6, arranged on the backboard 1, for cross-layer connecting the switch card and the line card.

In a preferred implementation process, the above backboard structure may also include: a fifth socket 3 for connecting the line card to the cable box 6, and a sixth socket 10 for connecting the cable box 6 to the line card;
a seventh socket 8 for connecting the switch card to the cable box 6, and an eighth socket 7 for connecting the cable box 6 to the switch card.

The fifth socket 3 and the sixth socket 10 are connected directly through the backboard 1. Or, the fifth socket 3 and the sixth socket 10 are indirectly connected through a ninth socket (not shown in the figure) arranged on the backboard 1.

As shown in FIG. 3a and 3b, the sixth socket 10 is arranged adjacent to the panel 12 of the switch card. In a preferred implementation mode, the second socket 9 and the sixth socket 10 are respectively arranged at both sides of the switch chip on the switch card, to ensure that the distance from the switch chip to the second socket 9 is equal to the distance from the switch chip to with the sixth socket 10.

As shown in FIG. 2b, the cable box 6 and the switch card are arranged at the same side of the backboard 1. The cable box 6 and the switch card are arranged in parallel.

The present embodiment also provides a centralized switching device, including a switch card, a line card and the above-mentioned backboard structure. The switch card is arranged at the back side of the backboard structure, and the line card is arranged at the front side of the backboard.

To better understand the above embodiments, they are illustrated in detail by combining with preferred embodiments hereinafter.

The present embodiment provides a backboard interconnection structure realized by using a cable, which can be used in a communication device adopting a centralized switching or branch structure, such as, optical transmission network (referred to as OTN for short), or packet transfer network (referred to as PTN for short), or router or the like.

The centralized switching device usually includes a plurality of line cards and a plurality of switch board cards. Every line card and every switch board card must have enough physical connection paths; and the high speed cables are used to implement the physical path connection, which is a new backboard technology. The new backboard technology can reduce the transmission loss, improve the connection distance, and thus improve the number of line cards and the maximum switching capacity of the device.

One of the basic functions required to be implemented by the backboard of the centralized switch device is to ensure that at least one connection path among all line cards and all switch cards; in that way, the data scheduling among any line cards can be implemented.

On the basis of that, the present embodiment further reduces the loss of the high-speed signal, increases the usable space of the line card, and provides greater device capacity which is larger than 50T and lager single slot line card access bandwidth 800G/1T.

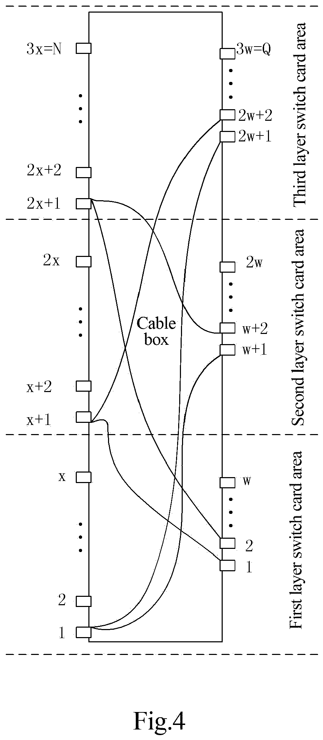

The device shapes in the present embodiment are as shown in FIG. 2a, FIG. 2b, FIG. 2c, FIG. 3a and 3b, and in FIG. 4.

Referring to FIG. 3a and 3b, the device based on the cable backboard of the present invention is composed of the following components:
1, a backboard PCB;
2, a socket for connecting the line card to the switch card (that is, the first socket 2);
3, a socket for connecting the line card to the cable box (that is, the fifth socket 3);
4, a line card PCB;
5, a line card panel;
6, a cable box;
7, a socket for connecting the cable box to the switch board (that is, the eighth socket 7);
8, a socket for connecting the switch card to the cable box (that is, the seventh socket 8);
9, a socket for connecting the switch card to the line card (that is, the second socket 9);
10, a socket for connecting the cable box to the line card (that is, the sixth socket 10);
11, a switch card PCB;
12, a switch card panel;
if the above components 2 and 9, 3 and 10, are not directly connected through the backboard, then there may also be the following optional components for transfer and interaction between 2 and 9, and 3 and 8.
13, a socket for connecting the backboard to the line card (not shown in figure);
14, a socket for connecting the backboard to the switch card (not shown in figure);
15, a socket for connecting the backboard to the cable box.

Herein, the components 2, 3, 4 and 5 constitute the line card unit. The components 1, 13, 14 and 15 constitute the backboard PCB unit. The components 6, 7 and 10 constitute the cable box unit. The components 8, 9, 11 and 12 constitute the switch card unit. The backboard PCB unit and the cable box unit can be collectively referred to as a cable backboard.

As shown in FIG. 2a and FIG. 2B, there are all line card slots at the front side of the backboard, and the line cards adopt transversely inserting design, and the number of the slots is N. There are vertically inserted switch cards of 2 to 4 layers at the back side of the device, and the number of the slots is M; the number of the slots on every layer is y, and the layer number of the devices is c. For the switch cards on a certain layer, the switch cards and the line cards on the corresponding layer at the front side are an orthogonal position relationship, which are directly interconnected through an orthogonal socket at the backboard side. That is, every line card is provided with y backboard sockets (components 2), and every switch card is provided with N/c backboard sockets (components 9), and the components 2 and 9 may select the orthogonal socket for direct mutual inserting, and may also be interconnected through the transfer of the components 13 and 14. By that way, it can be ensured that there is a pair of orthogonal sockets for connecting every switch card and every line card on the same layer, that is, the interconnection problem of the switch cards and the line cards on the same layer is solved. In addition, there is no backboard wiring when the orthogonal structure is adopted, which can guarantee that the PCB wiring of the data path is the shortest, and improve the transmission performance of high speed signals.

The data connection cross the device layers are implemented through the cable box. Referring to FIG. 2b, the cable box is also installed at the back side of the device, and is arranged in parallel with the switch card, and is longitudinal cross the position of all switch cards in one column. The sockets (components 10) at one side of the cable box are connected with all line card sockets (components 3), and the sockets (components 7) at another side are connected with the switch card sockets (components 8) in a corresponding column. The cable box is a pre-installed component, and the cable box is fixed on the device frame through a structural element before the device leaves factory. The line cards and the switch cards may be inserted into the corresponding slots of the device after leaving factory. The position of the component 8 is at the PCB side of the switch card without the switch clip, and the components 8 and the component 9 are respectively arranged at both sides of the switch chip, to ensure that the PCB wiring of the switch chip to the component 8 and the component 9 is as short as possible.

Referring to FIG. 4, the number of the sockets (components 10) connected with the line cards at the left side of the cable box is N, that is, every line card slot has one; the number of the sockets (components 7) connected with the switch cards at the right side is Q, which can be determined according to the socket type selection, while as long as that the numbers of the data paths of which the Q components 7 and the N components 10 for transmission are same. The cable box internally uses high speed cables to connect the components 7 and the components 10. Every component 10 is divided into (c-1) parts, and the (c-1) parts are respectively connected to the components 7 on non-same layers. In this way, the cable box can achieve the mutual connectivity among every line card and every switch card on all non-same layers. At the same time, the transmission loss of the high speed cable is very small relative to the PCB wiring, so that the loss of the whole transmission path can be controlled very low, to ensure the transmission performance of the high speed signal.

As the two main types of board cards of the device are arranged at the front side and the back side, the depths of the PCBs of the two may be designed respectively. The design of the switch board is relatively fixed, and the switch chip is the key, therefore, the depth of the switch card may be compressed as much as possible. In addition, the cable box and the switch card are arranged in parallel, and do not occupy additional device depth. However, for the line card, with the development of the technology, such as, optical module, etc., new function board card will be developed continuously, so the requirement for the PCB space is relatively large. The embodiments of the present invention can solve the problem of increasing the PCB space of the line card well.

### Embodiment 1

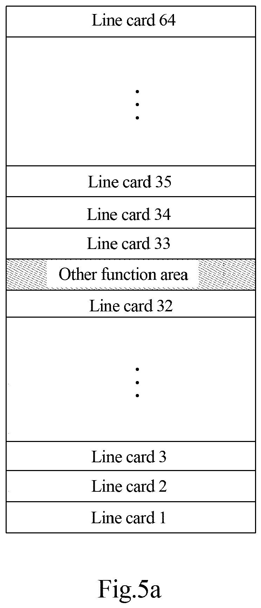

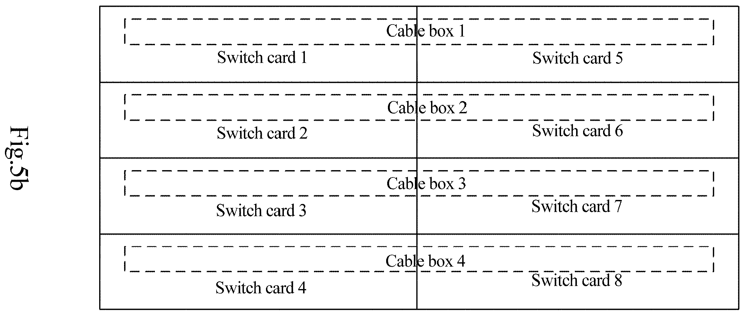

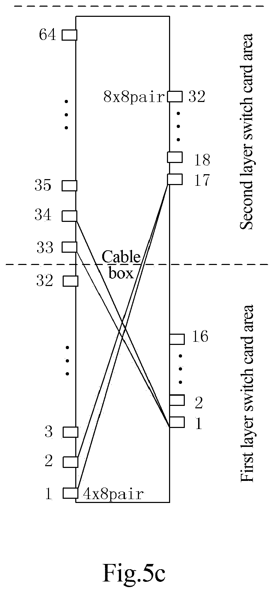

As shown in FIGS. 5a, 5b and 5c, the embodiment implements a design of 64-slot line cards and a single line card with an 800G bandwidth. The maximum capacity of the system is 51.2T.

A structure of a double-layer switch card is adopted. A single line card has an 800G bandwidth, and a single physical connection rate is selected as 25G. The single line card needs 48 channels to transmit data, and considering protection, 64 physical channels are needed in total. The number of the switch cards may be selected as 8 and a 6+2 protection mode is adopted according to structure limitation. The 64 channels of the line card are allocated to 8 switch cards, and each switch card has 8 channels. The interconnection sockets (components 3 and 10) of the cable box and the line card select 4x4pair, and support 8 channels. The interconnection sockets (components 2 and 9) of the line card and the switch card select 4x4pair, and support 8 channels. The interconnection sockets (components 7 and 8) of the cable box and the switch card select 4x8pair, and support 16 channels. Thereby, a pattern of the embodiment is as shown in FIGS. 5a, 5b and 5c. The basic parameters are as follows.
Line card number N=64,
Switch card number M=8,
Device layer number c=2,
The number of cross boards on a single layer y=4,
The number of line cards on a single layer x=32,
Cable box number y=4,
The number of sockets (components 2) for connecting each line card to the switch card: 4,
The number of sockets (components 3) for connecting each line card to the cable box: 4,
The number of sockets (components 10) for connecting each cable box to the line card: 64,
The number of sockets (components 7) for connecting each cable box to the switch card: 32,
The number of sockets (components 9) for connecting each switch card to the line card: 32,
The number of sockets (components 8) for connecting each switch card to the cable box: 16,
The components 3 and 10 lectotype: 4x4pair,
The components 2 and 9 lectotype: 4x4pair,
The components 7 and 8 lectotype: 4x8pair,
The number of cables in the cable box: 1024pair.

### Embodiment 2

The embodiment implements a design of 72-slot line cards and a single line card with a 1T bandwidth. The maximum capacity of the system is 72T.

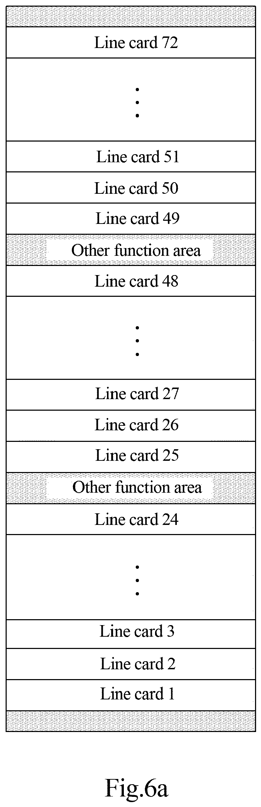

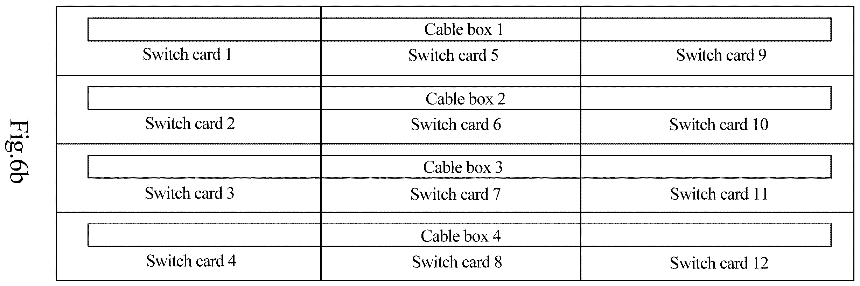

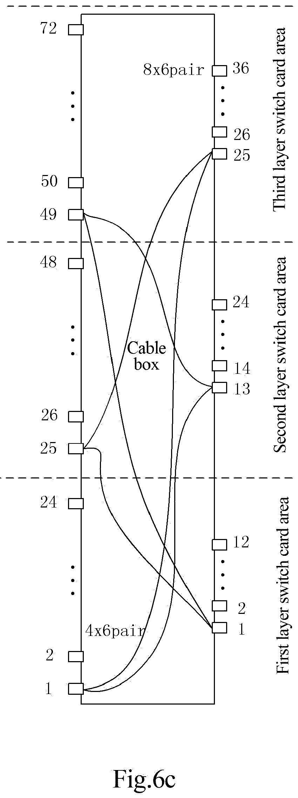

A structure of a three-layer switch card is adopted. A single line card has a 1T bandwidth, and a single physical connection rate is selected as 25G. The single line card needs 60 channels to transmit data, and considering protection, 72 physical channels are needed in total. The number of the switch cards may be selected as 12 and a 10+2 protection mode is adopted according to structure limitation. The 72 channels of the line card are allocated to 12 switch cards, and each switch card has 8 channels. The interconnection sockets (components 3 and 10) of the cable box and the line card select 4x8pair, and support 16 channels. The interconnection sockets (components 2 and 9) of the line card and the switch card select 4x4pair, and support 8 channels. The interconnection sockets (components 7 and 8) of the cable box and the switch card select 8x8pair, and support 32 channels. Thereby, a pattern of the embodiment is as shown in FIGS. 6a, 6b and 6c. The basic parameters are as follows.
Line card number N=72,
Switch card number M=12,
Device layer number c=3,
The number of crossboards on a single layer y=4,
The number of line cards on a single layer x=24,
Cable box number y=4,
The number of sockets (components 2) for connecting each line card to the switch card: 4,
The number of sockets (components 3) for connecting each line card to the cable box: 4,
The number of sockets (components 10) for connecting each cable box to the line card: 72,
The number of sockets (components 7) for connecting each cable box to the switch card: 36,
The number of sockets (components 9) for connecting each switch card to the line card: 24,
The number of sockets (components 8) for connecting each switch card to the cable box: 12,
The components 3 and 10 lectotype: 4x8pair,
The components 2 and 9 lectotype: 4x4pair,
The components 7 and 8 lectotype: 8x8pair,
The number of cables in the cable box: 2304pair.

### Embodiment 3

The embodiment implements a design of 80-slot line card and a single line card with a 1T bandwidth. The maximum capacity of the system is 80T.

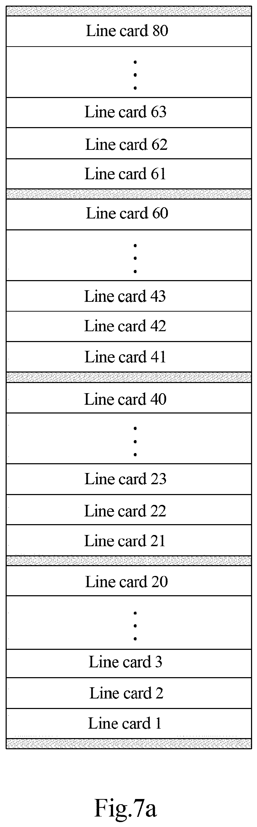

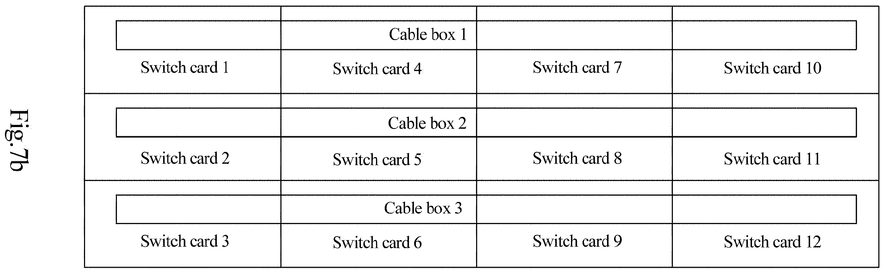

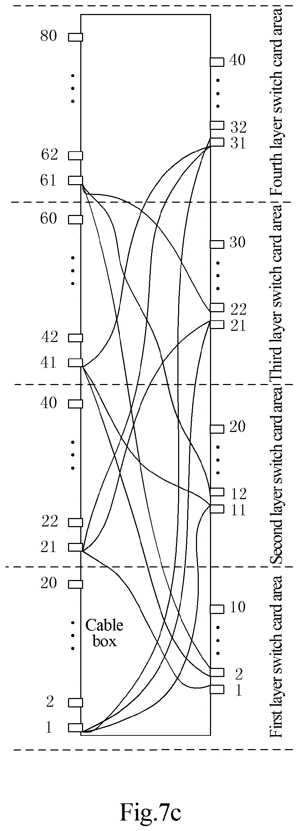

A structure of a four-layer switch card is adopted. A single line card has a 1T bandwidth, and a single physical connection rate is selected as 25G. The single line card needs 60 channels to transmit data, and considering protection, 72 physical channels are needed in total. The number of the switch cards may be selected as 12 and a 10+2 protection mode is adopted according to structure limitation. The 72 channels of the line card are allocated to 12 switch cards, and each switch card has 8 channels. The interconnection sockets (components 3 and 10) of the cable box and the line card select 6x8pair, and support 24 channels. The interconnection sockets (components 2 and 9) of the line card and the switch card select 4x4pair, and support 8 channels. The interconnection sockets (components 7 and 8) of the cable box and the switch card select 8x12pair, and support 48 channels. Thereby, a pattern of the embodiment is as shown in FIGS. 7a, 7b and 7c. The basic parameters are as follows.
Line card number N=80,
Switch card number M=12,
Device layer number c=4,
The number of crossboards on a single layer y=3,
The number of line cards on a single layer x=20,
Cable box number y=3,
The number of sockets (components 2) for connecting each line card to the switch card: 3,
The number of sockets (components 3) for connecting each line card to the cable box: 3,
The number of sockets (components 10) for connecting each cable box to the line card: 80,
The number of sockets (components 7) for connecting each cable box to the switch card: 40,
The number of sockets (components 9) for connecting each switch card to the line card: 20,
The number of sockets (components 8) for connecting each switch card to the cable box: 10,
The components 3 and 10 lectotype: 6x8pair,
The components 2 and 9 lectotype: 4x4pair,
The components 7 and 8 lectotype: 8x12pair,
The number of cables in the cable box: 3840pair.

The beneficial effects of the present embodiment are as follows:
By using the cable box and the orthogonal structure, the connection paths of every line card and every cross board are made as short as possible, which can fully meet the requirement for the path loss of the 25G/28G high speed signal. Through the parallel design of the cable box and the switch card and the line card independently occupying one side of the device, the PCB design space of the line card is increased as much as possible, to meet the requirement for the big capacity design of the single card. Furthermore, the scheduling capacity of the whole device can be improved, and the system capacity over 100T can be realized.

The above description is only the preferred embodiments of the present invention and is not intended to limit the present invention. For those skilled in the art, the present invention may have various modifications and variations. Any modification, equivalent and/or variation without departing from the rule and essence of the present invention should be embodied in the protection scope of the present invention.

### Industrial Applicability

Based on the above technical scheme provided by the embodiments of the present invention, by adopting a technical means of respectively disposing a first socket for connecting a line card to a switch card and a second socket for connecting the switch card to the line card at both sides of the backboard, problems of poor transmission performance of a backboard solution and small design space of a single board in the related art are solved. Therefore, the requirement for path loss of high-speed signals is met, and the design space of the single board is increased at the same time.

## Claims

1. A backboard structure, comprising:
a backboard;
a line card, arranged on a front surface of the backboard;
a switch card, arranged on a back surface of the backboard;
a first socket for connecting the line card to the switch card, arranged at the front side of the backboard;
a second socket for connecting the switch card to the line card, arranged at the back side of the backboard;
the first socket and the second socket are orthogonally arranged on a same layer;
**characterized in that** the backboard structure further comprises: a cable box, arranged on the backboard, for cross-layer connecting the switch card and the line card.

2. The backboard structure according to claim 1, wherein,
the first socket is directly connected with the second socket through the backboard.

3. The backboard structure according to claim 1, wherein the backboard structure further comprises:
the third socket, arranged on the backboard, and connected with the first socket;
a fourth socket connected with the third socket, arranged on the backboard, and connected to the switch card; and
the first socket is connected with the second socket through the third socket and the fourth socket.

4. The backboard structure according to claim 1, wherein the backboard structure further comprises:
a fifth socket for connecting the line card to the cable box, and a sixth socket for connecting the cable box to the line card; and
a seventh socket for connecting the switch card to the cable box, and an eighth socket for connecting the cable box to the switch card.

5. The backboard structure according to claim 4, wherein,
the fifth socket is directly connected with the sixth socket through the backboard; or, the fifth socket is indirectly connected with the sixth socket through a ninth socket arranged on the backboard.

6. The backboard structure according to claim 5, wherein, the sixth socket is arranged adjacent to a panel of the switch card.

7. The backboard structure according to claim 4, wherein, the second socket and the sixth socket are respectively arranged at both sides of a switch chip on the switch card.

8. The backboard structure according to claim 1, wherein, the cable box and the switch card are arranged at a same side of the backboard.

9. The backboard structure according to claim 8, wherein, the cable box and the switch card are arranged in parallel.

10. A centralized switching device, comprising a switch card and a line card, and further comprising: a backboard structure as described in any one of the claims 1-9.

## Patentansprüche

1. Rückbrettstruktur, umfassend: ein Rückbrett;
eine Line-Karte, die an einer Vorderfläche des Rückbretts angeordnet ist;
eine Switch-Karte, die an einer Rückfläche des Rückbretts angeordnet ist;
einen ersten Anschluss zum Verbinden der Line-Karte mit der Switch-Karte, angeordnet an der Vorderseite des Rückbretts;
einen zweiten Anschluss zum Verbinden der Switch-Karte mit der Line-Karte, angeordnet an der Rückseite des Rückbretts;
wobei der erste Anschluss und der zweite Anschluss orthogonal an einer gleichen Schicht angeordnet sind;
**dadurch gekennzeichnet, dass** die Rückbrettstruktur ferner Folgendes umfasst:
eine Kabelbox, angeordnet an dem Rückbrett, zum querschichtverbinden der Switch-Karte und der Line-Karte.

2. Rückbrettstruktur nach Anspruch 1, wobei
der erste Anschluss durch das Rückbrett direkt mit dem zweiten Anschluss verbunden ist.

3. Rückbrettstruktur nach Anspruch 1, wobei die Rückbrettstruktur ferner Folgendes umfasst:
den dritten Anschluss, der an dem Rückbrett angeordnet ist und mit dem ersten Anschluss verbunden ist;
einen mit dritten Anschluss verbundenen vierten Anschluss, der an dem Rückbrett angeordnet ist und mit der Switch-Karte verbunden ist; und
den ersten Anschluss, der mit dem zweiten Anschluss durch den dritten Anschluss und den vierten Anschluss verbunden ist.

4. Rückbrettstruktur nach Anspruch 1, wobei die Rückbrettstruktur ferner Folgendes umfasst:
einen fünften Anschluss zum Verbinden der Line-Karte mit der Kabelbox, und einen sechsten Anschluss zum Verbinden der Kabelbox mit der Line-Karte; und
einen siebten Anschluss zum Verbinden der Switch-Karte mit der Kabelbox, und einen achten Anschluss zum Verbinden der Kabelbox mit der Switch-Karte.

5. Rückbrettstruktur nach Anspruch 4, wobei
der fünfte Anschluss direkt mit dem sechsten Anschluss durch das Rückbrett verbunden ist; oder der fünfte Anschluss indirekt mit dem sechsten Anschluss durch einen neunten Anschluss, angeordnet an dem Rückbrett, verbunden ist.

6. Rückbrettstruktur nach Anspruch 5, wobei der sechste Anschluss neben einer Wand der Switch-Karte angeordnet ist.

7. Rückbrettstruktur nach Anspruch 4, wobei der zweite Anschluss und der sechste Anschluss jeweils an beiden Seiten eines Switchchips an der Switch-Karte angeordnet sind.

8. Rückbrettstruktur nach Anspruch 1, wobei die Kabelbox und die Switch-Karte an einer gleichen Seite des Rückbretts angeordnet sind.

9. Rückbrettstruktur nach Anspruch 8, wobei die Kabelbox und die Switch-Karte parallel angeordnet sind.

10. Zentralisierte Schaltvorrichtung, umfassend eine Switch-Karte und eine Line-Karte und ferner Folgendes umfassend: eine Rückbrettstruktur wie beschrieben nach einem der Ansprüche 1-9.

## Revendications

1. Structure de panneau arrière comprenant :
un panneau arrière,
une carte de lignes, agencée sur une surface avant du panneau arrière ;
une carte de commutation, agencée sur une surface arrière du panneau arrière ;
un premier support pour connecter la carte de lignes à la carte de commutation, agencé au côté avant du panneau arrière ;
un deuxième support pour connecter la carte de commutation à la carte de lignes, agencé au côté arrière du panneau arrière ;
le premier support et le deuxième support sont agencés orthogonalement sur la même couche ;
**caractérisée en ce que** la structure de panneau arrière comprend en outre :
une boîte de jonction, agencée sur le panneau arrière, pour une connexion intercouche de la carte de commutation et de la carte de lignes.

2. Structure de panneau arrière selon la revendication 1, dans laquelle
le premier support est directement connecté au deuxième support par l'intermédiaire du panneau arrière.

3. Structure de panneau arrière selon la revendication 1, dans laquelle la structure de panneau arrière comprend en outre :
un troisième support, agencé sur le panneau arrière et connecté au premier support ;
un quatrième support connecté au troisième support, agencé sur le panneau arrière et connecté à la carte de commutation ; et
le premier support est connecté au deuxième support par l'intermédiaire du troisième support et du quatrième support.

4. Structure de panneau arrière selon la revendication 1, dans laquelle la structure de panneau arrière comprend en outre :
un cinquième support pour connecter la carte de lignes à la boîte de jonction et un sixième support pour connecter la boîte de jonction à la carte de lignes ; et
un septième support pour connecter la carte de commutation à la boîte de jonction et un huitième support pour connecter la boîte de jonction à la carte de commutation.

5. Structure de panneau arrière selon la revendication 4, dans laquelle
le cinquième support est directement connecté au sixième support par l'intermédiaire du panneau arrière ; ou, le cinquième support est connecté indirectement au sixième support par l'intermédiaire d'un neuvième support agencé sur le panneau arrière.

6. Structure de panneau arrière selon la revendication 5, dans laquelle le sixième support est agencé de manière adjacente à un panneau de la carte de commutation.

7. Structure de panneau arrière selon la revendication 4, dans laquelle le deuxième support et le sixième support sont agencés respectivement des deux côtés d'une puce de commutation sur la carte de commutation.

8. Structure de panneau arrière selon la revendication 1, dans laquelle la boîte de jonction et la carte de commutation sont agencées au même côté du panneau arrière.

9. Structure de panneau arrière selon la revendication 8, dans laquelle la boîte de jonction et la carte de commutation sont agencées en parallèle.

10. Dispositif de commutation centralisé, comprenant une carte de commutation et une carte de lignes, et comprenant en outre : une structure de panneau arrière telle que décrite dans l'une quelconque des revendications 1 à 9.
